# EUROPEAN PATENT SPECIFICATION

(11) **EP 0 536 958 B1**
(45) Date of publication and mention of the grant of the patent: **15.01.1997**
(21) Application number: 92309006.2
(22) Date of filing: 02.10.1992
(51) Int. Cl.: C30B 15/00, C30B 33/00, C30B 29/06

(54) **Process for producing a semiconductor wafer**
Verfahren zur Herstellung einer Halbleiter-Scheibe
Procédé de production d'une plaquette de semi-conducteur

(30) Priority: 07.10.1991 JP 289155/91
(43) Date of publication of application: 14.04.1993
(73) Proprietor: Shin-Etsu Handotai Co., Ltd, Chiyoda-ku Tokyo (JP)
(72) Inventor: Otokawa, Takao, c/o Semiconductor Res., Ins. of, Annaka-shi, Gunma-ken (JP); Isuda, Nobuhiro, c/o Semiconductor Res., Ins. of, Annaka-shi, Gunma-ken (JP); Ushio, Satoshi, c/o Semiconductor Res., Ins. of, Annaka-shi, Gunma-ken (JP); Takenaka, Takao, c/o Semiconductor Res., Ins. of, Annaka-shi, Gunma-ken (JP)
(74) Representative: Perry, Robert Edward

(56) References cited:
- EP-A- 0 391 709
- PATENT ABSTRACTS OF JAPAN vol. 13, no. 439 (E-827)3 October 1989
- JAPANESE JOURNAL OF APPLIED PHYSICS, SUPPLEMENTS. vol. 21, no. 1, 1982, TOKYO JA pages 105 - 111 KISHINO 'microdefects in czochralski-grown silicon crystals and their application to gettering technique'

## Description

### BACKGROUND OF THE INVENTION

### 1. Field of the Invention

The present invention relates to a process for producing a semiconductor wafer for fabrication of semiconductor integrated circuit and more particularly to a process for producing a semiconductor wafer having a denuded zone (DZ) free from defects after a process of intrinsic gettering the wafer.

### 2. Description of the Related Art

Intrinsic gettering (IG) has been employed as a technique of eliminating defects formed during silicon single crystal growth from the active layer (i.e. DZ layer) positioned near a surface of the semiconductor wafer. Intrinsic gettering process is a method of creating defects inside a semiconductor wafer instead of from outside the wafer to cause the wafer to have a gettering ability.

Intrinsic gettering process normally comprises in an order of execution the three following steps of first annealing the wafer to create the denuded zone at approximately 1050-1200°C, second annealing the wafer to create defect nuclei inside the wafer at approximately 600-800°C and last annealing the wafer to concentrate microdefects to around the defect nuclei inside the wafer at approximately 1000°C. Japanese unexamined patent application publication HEI.1-168031 discloses this intrinsic gettering process in detail.

It is an ideal that the denuded zone is perfectly free from defects after the wafer has been subjected to intrinsic gettering process. However, it is found that low density defects actually remain in the denuded zone. These defects cause a fatal drawback in case electronic devices on the wafer are decreased in size.

The present inventors have found through researches from various viewpoints causes why the low density defects remain in the denuded zone and discovered that a mechanism of creating the defects was complicated and conditions for heat treatment for the intrinsic gettering process and especially an initial concentration of oxygen and a pulling-up speed of a silicon single crystal rod in Czochralski method largely affects the creation of the defects. Thus, the inventors studied a degree of the effect and measures to prevent the creation of the defects and have made the present invention.

### SUMMARY OF THE INVENTION

An object of the present invention is to provide a process for producing a silicon single crystal wafer having a substantially perfect denuded zone using an as-grown silicon single crystal wafer sliced from a silicon single crystal rod produced by Czochralski method.

According to the present invention, a process for producing a semiconductor wafer comprises the steps of:
growing a silicon single crystal by the Czochralski method;
drawing a rod of the silicon single crystal, having an oxygen concentration of 14-20 ppma;
slicing a silicon single crystal wafer from the rod; and
subjecting the wafer to an intrinsic gettering process composed of a high-temperature annealing step, a low-temperature annealing step, and an intermediate temperature annealing step, carried out successively in the order named, and is characterised by drawing the rod at a speed of no more than 0.6 mm/min.

Pulling up the single crystal rod at more than 0.6 mm/min significantly increased the number of macrodefects in the single crystal rod induced during growth of the single crystal in Czochralski method.

Doping the wafer with oxygen of less than 14 ppma significantly decreases the number of defects outside a denuded zone of the wafer to create no high-density defect layer and thereby reduce a gettering effect. On the other hand, doping the wafer with oxygen of more than 20 ppma significantly increases oxygen precipitates (i.e. defects) in and near the surface of the wafer. The oxygen precipitates degraded the mechanical strength of the wafer after the wafer was subjected to the intrinsic gettering process to tend to cause a warp or a slip in the wafer.

In the present invention, the wafer has little number of macrodefects induced during growth of the single crystal and a high-temperature heat treatment of the wafer dissolves almost all of these macrodefects in and near the surface of the wafer having a small amount of oxygen at a high temperature. Thus, the wafer has an approximately ideal denuded zone layer (i.e. having a much smaller number of defects than a prior art silicon single crystal wafer.

### BRIEF DESCRIPTION OF THE DRAWINGS

FIG.1 is a side elevation of a semiconductor single crystal wafer produced by the process for producing a semiconductor wafer according to an embodiment of the present invention;
FIG.2 is a diagrammatic plan view of the wafer of FIG.1, showing an LD (i.e. line defect) ring represented by X-ray topography;
FIG.3 illustrates a mechanism of creating macrodefects; and
FIG.4 illustrates a mechanism of creating further macrodefects.

### DESCRIPTION OF THE PREFERRED EMBODIMENT

A preferred embodiment of the present invention will be described with reference to the drawings hereinafter.

### TEST 1

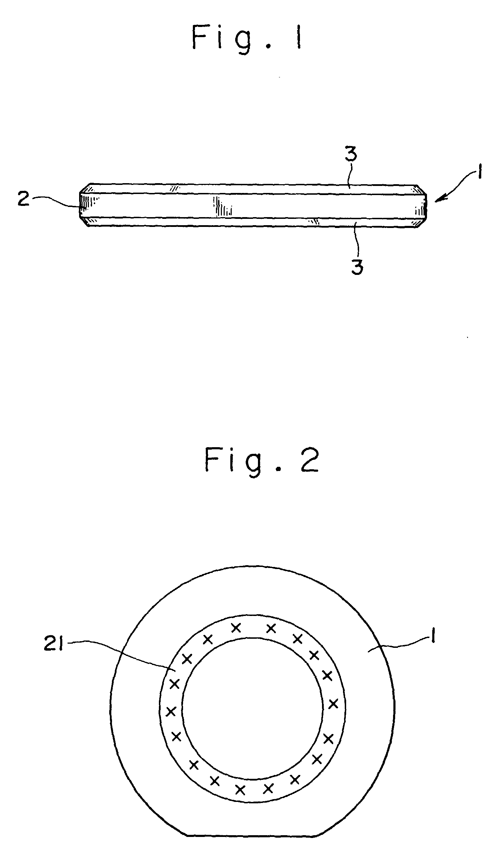

Starting silicon single crystal wafers sliced from silicon single crystal rods in Czochralski method having different pulling-up speeds were subjected to an intrinsic gettering process (i.e. comprising heat treatments) under the same conditions to produce silicon single crystal wafers 1 having a high-density defect layer 2 and a denuded zone (i.e. defect-free layer) 3 as shown in FIG.1.

Spatial defect distributions of the wafers 1 were examined. Contents of oxygen of the starting wafers were 14-20 ppma.

### 1. CONDITIONS

P type semiconductor wafers with a diameter of 125 mm which were produced under the following conditions 1.1 and 1.2 and had a pulling-up direction of <100> and resistivities of 10-13 Ω·cm were observed under the following condition 1.3.

### 1.1 PULLING-UP SPEED

1) 1.54 mm/min,
2) 1.25 mm/min,
3) 0.6 mm/min, and
4) 0.4 mm/min

### 1.2 CONDITION FOR HEAT TREATMENT

1) At 800°C in an atmosphere of nitrogen (N₂) for 4 hr and subsequently at 1000°C in an atmosphere of dry oxygen (O₂) for 16 hr;
2) At 1100°C in the atmosphere of nitrogen for 2 hr, subsequently at 650°C in the atmosphere of nitrogen for 20 hr and subsequently at 1000°C in the atmosphere of dry oxygen for 16 hr;
3) At 1200°C in the atmosphere of nitrogen for 2 hr and subsequently 1000°C in the atmosphere of dry oxygen for 16 hr;
   and
4) At 1280°C in the atmosphere of nitrogen for 2 hr and subsequently 1000°C in the atmosphere of dry oxygen for 16 hr.

### 1.3 METHOD OF OBSERVATION

By X-ray topography.

### 2. RESULTS

It was observed that the peripheral regions of wafers having the pulling-up speeds of 1.54 mm/min and 1.25 mm/min had defects regardless of the natures of the heat treatments listed above. Although the number of defects were reduced as the temperature of the heat treatments were increased, it was observed that the defects remained in the wafers.

On the other hand, it was observed that peripheral regions of wafers 1 having the pulling-up speeds of 0.6 mm/min and 0.4 mm/min had no defects regardless of the natures of the heat treatments listed above. It was observed that a very small number of defects dotted the central area of each of these wafers 1.

### TEST 2

Since the X-ray topography across the wafer surface produces only an image in which all data are superposed in the direction of the thickness of the wafer, a distribution of defect in the depth of the wafer was examined on TEST 2 in which contents of oxygen in starting wafers were 14-20 ppma.

### 1. CONDITIONS

P type semiconductor wafers with a diameter of 125 mm which were produced under the following conditions 1.1 and 1.2 and had a pulling-up direction of <100> and resistivities of 10-13 Ω·cm were observed under the following condition 1.3.

### 1.1 PULLING-UP SPEED

1) 1.54 mm/min,
2) 1.25 mm/min,
3) 0.6 mm/min, and
4) 0.4 mm/min

### 1.2 CONDITIONS FOR HEAT TREATMENT

At 1100°C in the atmosphere of nitrogen for 2 hr, subsequently at 650°C in the atmosphere of nitrogen for 20 hr and subsequently at 1000°C in the atmosphere of dry oxygen for X hr where X was 0, 4, 8 and 16.

### 1.3 METHOD OF OBSERVATION

All wafers were angularly polished under the condition of tan θ = 0.1 and then secco etched for 1 min. The resulting wafers were observed by means of an optical microscope.

### 2. RESULTS

It was observed that denuded zones of the peripheral regions of wafers having the pulling-up speeds of 1.54 mm/min and 1.25 mm/min had defects regardless of the natures of the heat treatments listed above.

On the other hand, it was observed that wafers 1 having the pulling-up speeds of 0.6 mm/min and 0.4 mm/min had little number of defects. In detail, the denuded zones of the edges of the wafers having the pulling-up speeds of 1.54 mm/min and 1.25 mm/min had defects of approximately 5×10⁸/cm³ and the denuded zones of the central portions of the wafers having the pulling-up speeds of 0.6 mm/min and 0.4 mm/min had defects of approximately 10³/cm³.

### 3. OTHER TESTS

It was supposed from TESTS 1 and 2 that the creation of defects in a wafer after intrinsic gettering process primarily depends on a pulling-up speed of a single crystal rod in the Czochralski method. In another test, starting wafers (i.e. as-grown wafers by the Czochralski method) were heat treated at 1280°C for 2 hr and subsequently at 1000°C for 16 hr. The resulting wafers were observed. It was found that macrodefects (i.e. clusters mainly comprising oxygen precipitates) were produced in the wafers. Creation of these macrodefects depends on the pulling-up speed of the single crystal rod in the Czochralski method. Wafers sliced from single crystal rods having low pulling-up speeds (i.e. 0.6 mm/min or less) had much smaller number of macrodefects than other wafers sliced from single crystal rods having the pulling-up speeds higher than 0.6 mm/min. The wafers were tested on OSF at 120°C in an atmosphere of wet gaseous oxygen for 60 min. It was found that the wafer 1 sliced from the single crystal rod having the pulling-up speed of higher than 0.6 mm/min had an LD (i.e. Line defect) ring 21 as shown in FIG.2.

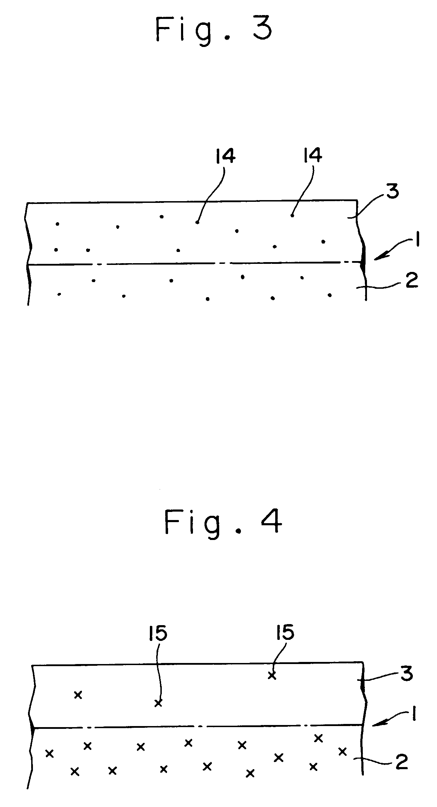

Thus, it is supposed that the defects are created in the following process. The starting wafer sliced from the single crystal rod having the pulling-up speed of higher than 0.6 mm/min had a widely spreading distribution of a great number of macrodefects 14 (i.e. clusters mainly comprising oxygen precipitates) as shown in FIG.3. Part of these macrodefects 14, as shown in FIG.4, is dissolved in the wafer during high-temperature heat treatment of the wafer at 1100°C or higher. Remaining macrodefects 14 grow during subsequent intermediate-temperature heat treatment of the wafer at approximately 1000°C to become larger macrodefects 15 in the denuded zone 13 of the wafer.

That is, oxygen in the starting wafer 1 is diffused outward during the high-temperature heat treatment to decrease the concentration of oxygen near the surface of the wafer 1. Thus, a critical radius (i.e. radius for determining the growth or disappearance of the oxygen precipitates) is increased near the surface of the wafer where the concentration of oxygen is low and the temperature is high, so that precipitates having radii smaller than the critical radius are dissolved in the wafer. On the other hand, precipitates having radii equal to or more than the critical radius cannot be dissolved but grow. Thus, it is supposed that these precipitates will create macrodefects 15 in the denuded zone 3 after the intrinsic gettering process of the wafer.

Since a decreasing of the concentration of oxygen in the starting wafer under the lower limit of the concentration of oxygen makes it difficult to produce a high-density defect layer, the intrinsic gettering effect of the wafer was decreased and the wafer was warped. On the other hand, since an increasing of the concentration of oxygen in the starting wafer beyond the upper limit of the concentration of oxygen remarkably increased the precipitates in and near the surface of the wafer and an excess of the precipitates significantly degraded the mechanical strength of the wafer after the intrinsic gettering process, the wafer tends to be warped or have a slip. Thus, an actual appropriate concentration of oxygen in the starting wafer is 14-20 ppma.

## Claims

1. A process for producing a semiconductor wafer, which comprises the steps of:
growing a silicon single crystal by the Czochralski method;
drawing a rod of the silicon single crystal, having an oxygen concentration of 14-20 ppma;
slicing a silicon single crystal wafer from the rod; and
subjecting the wafer to an intrinsic gettering process composed of a high-temperature annealing step, a low-temperature annealing step, and an intermediate temperature annealing step, carried out successively in the order named, characterised by drawing the rod at a speed of no more than 0.6 mm/min.

## Patentansprüche

1. Verfahren zur Herstellung einer Halbleiter-Scheibe, welches die folgenden Schritte umfaßt:
- Züchten eines Silizium-Einkristalls nach dem Czochralski-Verfahren;
- Ziehen des Silizium-Einkristalls mit einer Sauerstoff-Konzentration von 14-20 ppma zu einem Stab;
- Schneiden einer Silizium-Einkristall-Scheibe von dem Stab und
- Anwendung eines inneren Getter-Verfahrens auf die Scheibe, bestehend aus einem Temperschritt bei hoher Temperatur, einem Temperschritt bei niedriger Temperatur und einem Temperschritt bei mittlerer Temperatur, die nacheinander in der genannten Reihenfolge durchgeführt werden,
dadurch gekennzeichnet, daß der Stab mit einer Geschwindigkeit von nicht mehr als 0,6 mm/Min. gezogen wird.

## Revendications

1. Procédé de production d'une plaquette de semiconducteur qui comprend les étapes :
de croissance d'un monocristal de silicium par le procédé de Czochralski ;
de tirage d'une barre de monocristal de silicium ayant une concentration en oxygène de 14 à 20 ppma ;
de découpage d'une plaquette de monocristal de silicium à partir de la barre ; et
de soumission de la plaquette à un traitement de fixation intrinsèque des gaz composé : d'une étape de recuit à haute température, d'une étape de recuit à basse température, et d'une étape de recuit à température intermédiaire, exécutées successivement dans l'ordre énoncé, caractérisé par le tirage de la barre à une vitesse qui n'est pas supérieure à 0,6 mm/min.
